# EUROPEAN PATENT SPECIFICATION

(11) **EP 2 487 351 B1**
(45) Date of publication and mention of the grant of the patent: **09.09.2015**
(21) Application number: 10821745.6
(22) Date of filing: 06.10.2010
(51) Int. Cl.: F02D 9/10, H05K 5/00, H01R 12/72, F02D 11/10

(54) **CIRCUIT MODULE HAVING CONNECTOR(S)**
SCHALTKREISMODUL MIT STECKER(N)
MODULE DE CIRCUITS POURVU DE CONNECTEUR(S)

(30) Priority: 06.10.2009 JP 2009232090
(43) Date of publication of application: 15.08.2012
(73) Proprietor: Hitachi Automotive Systems, Ltd., Hitachinaka-shi Ibaraki 312-8503 (JP)
(72) Inventor: TAKEUCHI, Yutaka, Hitachinaka-shi Ibaraki 312-8503 (JP); HATSUZAWA, Hidefumi, Hitachinaka-shi Ibaraki 312-8503 (JP); ISHIHARA, Kazuya, Hitachinaka-shi Ibaraki 312-8503 (JP)
(74) Representative: MERH-IP Matias Erny Reichl Hoffmann
(86) International application number: PCT/JP2010/005994
(87) International publication number: WO 2011/043070

(56) References cited:
- WO-A1-00/58614
- WO-A1-2009/010705
- JP-A- 2001 124 509
- JP-A- 2002 368 450
- JP-U- 58 092 784
- US-A- 4 703 649

## Description

### Technical Field

The present invention relates to a circuit module having a connector and more particularly to a circuit board mounting structure for connecting between a circuit board and a connector terminal conductor in the circuit module.

The circuit module is, for example, for a motor-driven throttle valve device which drives a throttle valve by a motor to control the opening area of an air passage in an internal combustion engine electrically. The present invention concerns, for example, a circuit board mounting structure for connecting between terminal conductors on a signal processing circuit board of a rotation angle sensor of the throttle valve and connector-side terminal conductors of the connector provided on a cover.

### Background Art

The structure described in JP-U-Sho 63-14868 is known as a structure for connecting between connector terminal conductors and an electric circuit.

The structure described in JP-A-2008-96231 is also known as a circuit board mounting structure for connecting between circuit board-side terminals used for the rotation angle sensor of a motor-driven throttle valve control device and connector-side terminal conductors provided on a cover and also known as a structure for fixing the circuit board on the cover.

### Citation List

### Patent Literature

Patent Literature 1: JP-U-Sho 63-14868
Patent Literature 2: JP-A-2008-96231

### Summary of Invention

### Technical Problem

Conventionally, a circuit board has been fixed on a member provided with a connector (a cover member for the sensor or a gear cover member of the motor-driven throttle valve controller in Patent Literature 2) with an adhesive agent or screw; and conductor parts on the circuit board and connector-side terminal conductors have been electrically connected respectively by welding each both ends of the lead terminal conductors to the conductor parts on the circuit board and the connector-side terminal conductors.

The above-mentioned conventional structure has some problems that a large number of components and a large number of assembling steps for the device are required, and there is difficulty in a man-hour management to control adhesive drying conditions and welding current conditions in the bonding and welding processes.

An object of the present invention is to provide a circuit module having a circuit board mounting structure with high assemblability for connecting between this kind of circuit board and connector-side terminal conductors.

### Solution to Problem

In order to achieve the above object of the present invention, provided is a circuit module having a connector according to claim 1.

### Advantageous Effects of Invention

By adopting the circuit board mounting structure for connecting between the circuit board and the resin molded member (module housing, sensor cover, gear cover or connector member) having a connector and , it is possible to mechanically fix the circuit board on the resin molded member (module housing, sensor cover, gear cover or connector member) having the connector without an adhesive agent and electrically connect between the circuit board and the connector of the resin molded member at a time, so the number of components and the number of assembling steps for the device can be reduced.

### Brief Description of Drawings

[Fig. 1] a sectional view illustrating an essential part of a circuit board mounting structure for connecting between the circuit board to connector terminal conductors in a circuit module according to an embodiment of the present invention;
[Fig. 2] a perspective view illustrating a circuit module according to another embodiment of the present invention which is applied to the inductance type rotation angle sensor in a motor-driven throttle valve controller and a view taken from the direction of arrow P;
[Fig. 3] a perspective view illustrating the circuit module illustrated in Fig. 2 before it is mounted on the motor-driven throttle valve control device or after it is removed from the motor-driven throttle valve control device; and
[Fig. 4] a sectional view of the whole motor-driven throttle valve control device.

### Description of Embodiments

Next, embodiments of the present invention will be described referring to drawings.

### First Embodiment

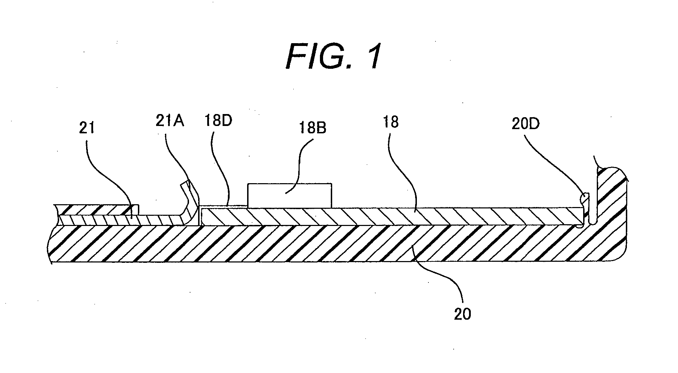

Fig. 1 is a partial view illustrating a mounting structure for connecting between a circuit board and a connector terminal conductor in a circuit module according to an embodiment of the present invention.

A resin molded member 20 formed integrally with a connector 20B may be referred to as a module casing for housing the circuit board or a connector member, and, depending on the application purpose, it may be referred to as a sensor cover, gear cover or the like. Each of stoppers 20D, which retains (restrains) an one-side edge of a circuit board 18 by a hooked portion of the stopper, is provided on a surface of the cover 20, for example, an inner surface thereof. Each stopper 20D is formed as an elastic projection or in the form of a wall, and molded together with the resin molded member 20 (as module casing, sensor cover, gear cover, or connector member).

In addition, the resin molded member 20 (module casing, sensor cover, gear cover or connector member) is provided with a plurality of connector-side terminal conductors 21 on an inside of the resin molded member with insert molding such that the connector-side terminal conductors 21 are partially exposed on the resin molded member 20 at an one end side respectively. The one end side portion of each connector-side terminal conductor 21 is formed in a hooked shape (curved portion) so as to be an elastic part 21A having elasticity. The elastic part 21A of each terminal conductor 21 is located opposite to the stopper 20D, across an installation space of the circuit board 18 from the elastic part 21A.

The circuit board 18 is caught by the stoppers 20D of the resin molded member 20 (module casing, sensor cover or gear cover) and the elastic parts 21A of the connector-side terminal conductors 21.

In this state, the elastic parts 21A of the connector-side terminal conductors 21 are pressed against corresponding conductor parts 18D on the circuit board 18, thereby making an electrical connection between the connector-side terminal conductors 21 and the conductor part 18D of the circuit board 18 respectively.

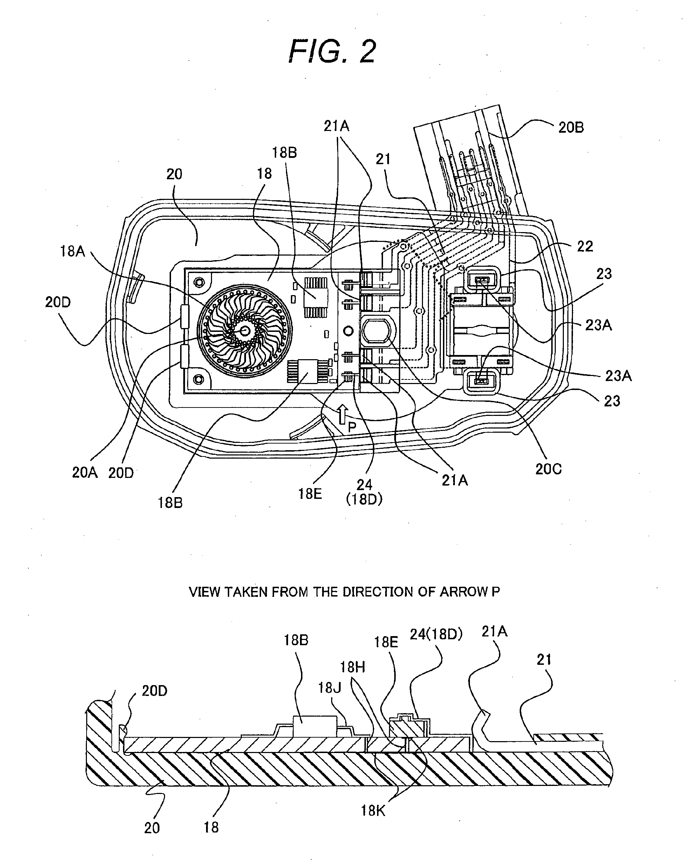

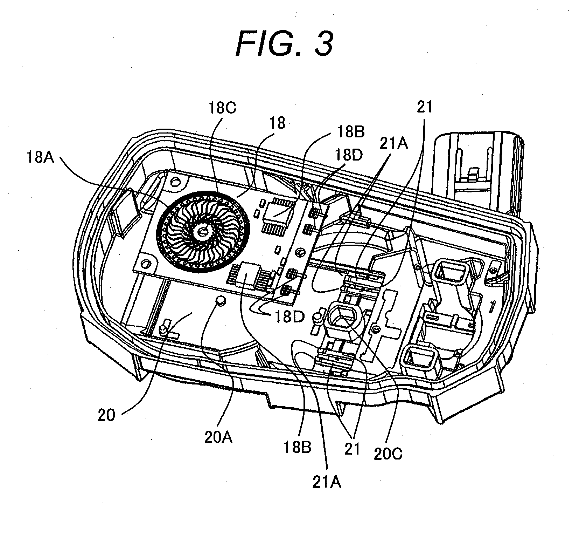

Fig. 2 is a plan view of a motor-driven throttle valve controller to which a signal processing circuit board of an inductance type rotation angle sensor is attached, and Fig. 3 is an exploded perspective view thereof. The above circuit module is applied to this motor-driven throttle valve controller. In a circuit board mounting structure for connecting between the circuit board for the throttle valve controller and the connector-side terminal conductors, the circuit board is caught between the elastic projection and the connector-side terminal conductor as in Fig. 1, though there is some modification to the structure illustrated in Fig. 1.

A stationary-side annular excitation conductor 18A is printed on the circuit board 18 as a sensor signal processing circuit board and this conductor is a part which senses a rotational position. Also an electronic circuit including microcomputers 18B is attached onto the circuit board 18 and this circuit controls the operation of the rotational position sensing part and processes an output signal.

The circuit board 18 is fixed on the resin molded member 20 as a module casing (how it is fixed will be described later). The resin molded member 20 not only functions as a sensor cover housing components for the rotation angle sensor but also serves as a gear cover housing the gear mechanism of a throttle valve drive mechanism (not illustrated) and a connector member having a connector. When fixing the circuit board 18, a position of the circuit board 18 on the resin molded member 20 is determined by a through hole 18C made in the center of the circuit board 18 and a projection 20A formed on the resin molded member 20.

The inside of the resin molded member 20 is provided with six connector-side terminal conductors 21 made of conductive material by insert-molding. The connector-side terminal conductors 21 comprise four terminal conductors used for the sensor and two terminal conductors 22 used for a motor. The respective ends of the terminal conductors are put together in a female plug-in connector 20B formed in the resin molded member 20.

When installing the module in a vehicle, the male plug-in connector (not illustrated), which is provided at one end of an electric wire (not illustrated) extending from an engine control unit (not illustrated), is inserted into the female plug-in connector 20B, so that the six connector-side terminal conductors (21 and 22) are electrically connected with the engine control unit to send and receive electric signals.

In a pair of the terminal conductors 22 used for the motor, the other ends (not illustrated) thereof, which are opposite to the female plug-in connector 20B, extend into the motor terminal conductor insertion area 23. The motor terminal conductor insertion area 23 is molded integrally with the resin molded member 20 so as to protrude from the inside of the resin molded member 20. So the other ends of the terminal conductors 22 are electrically connected with relay couplings 23A provided inside the motor terminal conductor insertion area 23. An electric connection between the terminal conductors 22 and the motor 2 is made by inserting motor-side terminal conductors '2B extending from the motor 2 into the relay couplings 23A.

Elastic parts 21A of the connector-side terminal conductors 21, which are opposite to the female plug-in connector 20B, are exposed on the inner surface of the resin molded member 20 near the circuit board 18.

In the embodiment illustrated in Fig. 2, lead terminal conductors 24 (which corresponds to the conductor parts 18D in Fig. 1), each which is welded to a welding-use projection 18E of conductive material provided on the circuit board 18, extend up to an edge at one end of the circuit board 18 as illustrated in the view taken from the direction of arrow P in Fig. 2. The elastic parts 21A at the respective one ends of the connector-side terminal conductors 21 extend over the corresponding lead terminal conductors 24 so as to be pressed against the lead terminal conductors 24, so that the connecter-side terminal conductors and the lead terminal conductors are electrically connected to each other respectively. In addition to that, at a time, the circuit board 18 itself is pressed against the resin molded member 20 by the elastic parts 21A so as to be fixed. The welding-use projections 18E made of conductive material are electrically connected with corresponding circuit elements respectively. Also as illustrated in the view taken from the direction of arrow P in Fig. 2, the microcomputer 18B and the welding-use projections 18E are electrically connected through lead terminals 18J of the microcomputer 18B, via holes 18H made in the circuit board 18 and conductors 18K printed on the front and back surfaces of the board 18. The welding-use projections 18E are connected to the conductors 18K by an appropriate means such as soldering or brazing.

Here, each welding projection 18E made of conductive material and each lead terminal conductor 24 with one end welded to the projection may be constituted by a single conductor like the conductor part 18D illustrated in Fig. 1. Specifically, the projection 18E made of conductive material itself is formed so as to extend to the edge of the circuit board 20 as illustrated in Fig. 1 so that the elastic part 21A at the one end of the connector-side terminal conductor 21 is pressed against the edge resulting in free of welding.

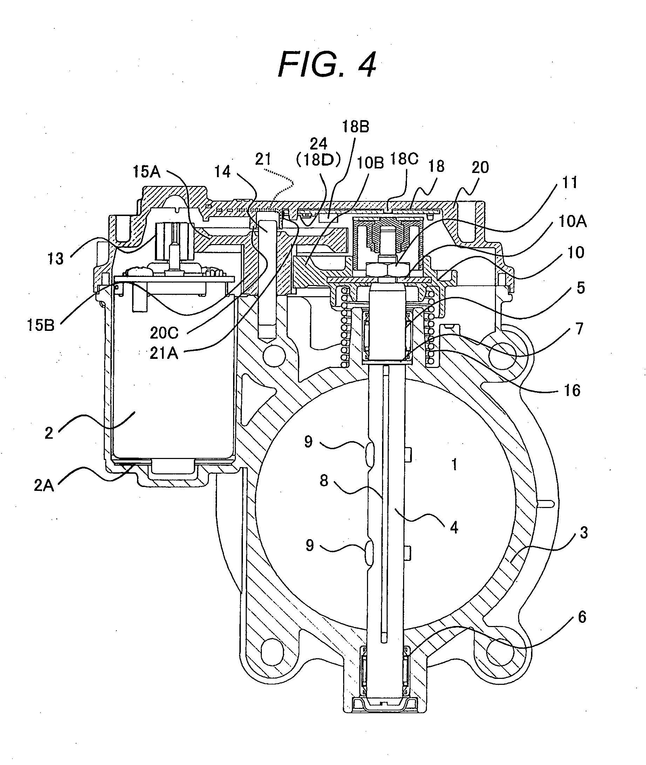

Fig. 4 is a sectional view of the whole motor-driven throttle valve controller in which the circuit module illustrated in Figs. 2 and 3 is mounted.

In an aluminum die cast throttle valve assembly (hereinafter referred to as a throttle body) 3, an intake air passage 1 (hereinafter referred to as a bore) and a motor housing 2A for housing the motor 2 are formed integrally with each other.

In the throttle body 3, a metal rotating shaft (hereinafter referred to as a throttle shaft) 4 is provided along a diameter of the bore 1. Both ends of the throttle shaft 4 are rotatably supported by needle bearings 5 and 6. The needle bearings 5 and 6 are press-fitted into the throttle body 3. Also, the amount of movement of the throttle shaft 4 in the axial direction is limited by inserting a C-shaped washer (hereinafter referred to as a thrust retainer) 7 in a slit on the throttle shaft 4 and then pressing the needle bearing 5 inwards.

A metal circular disc-valve (hereinafter referred to as a throttle valve) 8 is inserted in the slit of the throttle shaft 4 and fixed in the throttle shaft 4 with screws 9.

Thus, as the throttle shaft 4 rotates, the throttle valve 8 rotates and as a consequence the opening area of the intake air passage changes, making it possible to control an intake air rate of the internal combustion engine.

A throttle gear 10 is fixed at one end of the throttle shaft 4 with a nut 11. The throttle gear 10 is comprised of a metal plate 10A and a gear part 10B resin-molded on the metal plate 10A.

The motor housing 2A is formed in parallel with the throttle shaft 4 and a brush DC motor 2 is placed into the motor housing 2A and fixed with screws 12. A metal gear (hereinafter referred to as a motor pinion) 13, which has the smallest number of teeth among gears, is fixed on an end of the rotating shaft of the motor 2.

A gear (hereinafter referred to as an intermediate gear) 15 supported rotatably by an intermediate gear shaft 14 as a metal shaft press-fitted in the throttle body 3, is engaged between the motor pinion 13 and the throttle gear 10. The intermediate gear 15 is comprised of a large-diameter gear 15A to be engaged with the motor gear 13 and a small-diameter gear 15B to be engaged with the throttle gear 10. Both the gears are integrally formed with each other by resin molding.

These gears 13, 15A, 15B and 10 constitute a double reduction gear mechanism so that rotation of the motor 2 is transmitted through the reduction mechanism to the throttle shaft 4.

A return spring 16 formed as a coiled spring is interposed between a back side of the throttle gear 10 and a lateral side of the throttle body 3. One end of the return spring 16 is hooked to a notch made in the throttle body 3 and the other end thereof is hooked to a notch made in the throttle gear 10. The return spring 16 is given a preload in the direction of rotation so as to keep the throttle valve 8 fully open while the motor 2 is not turned on.

The abovementioned circuit module in Figs. 2 and 3, namely the resin molded member 20 including the connector 20B and the circuit board 18 and having the structure for connecting between the circuit board and connector terminal conductors which characterizes this embodiment, is attached so as to cover the reduction gear mechanism which is located on the throttle body 3 and a lateral side of the motor housing. Upon attachment of the resin molded member 20, a rotatable excitation conductor (inductance type rotation angle sensor) in the form of a rotating plate located at one end of the throttle shaft 4 faces the stationary-side excitation conductor 18 of the abovementioned circuit module (resin molded member 20). The inductance type rotation angle sensor can sense a rotational angle as a rotational position of the rotatable excitation conductor, by taking advantage of the fact that the inductance between the rotatable excitation conductor attached to the rotating shaft and the stationary-side excitation conductor varies depending on a positional relation between both excitation conductors. Since such an inductance type rotation angle sensor is an already known technique (for example, JP-A-2008-96231), detailed description thereof is omitted here.

This embodiment although has been described as a concrete example of the mounting structure of the signal processing circuit board of the inductance type rotation angle sensor being mounted in the motor-driven throttle valve controller, generally the invention may be widely used as a mounting structure having such a circuit board fixed on a member with a connector formed thereon, terminal conductors used for the circuit board, and terminal conductors used for the connector electrically being connected to each other.

### Reference Signs List

1: Bore, 2: Motor, 2A: Motor housing, 2B and 22: Motor side terminal conductor, 3: Throttle body, 4: Throttle shaft, 5 and 6: Needle bearing, 7: Thrust retainer, 8: Throttle valve, 9 and12: Screw, 10: Throttle gear, 10A: Throttle gear metal plate, 10B: Gear part of throttle gear, 11: Nut, 13: Motor gear, 14: Intermediate gear shaft, 16: Return spring, 18: Circuit board, 18A: Excitation conductor, 18B: Microcomputer, 18C: Through hole, 18D: Conductorpart, 20: Resin molded member (module casing, sensor cover, gear cover, connector member), 20A: Projection 20B: Female plug-in connector, 20C: Intermediate gear boss, 20D: Stopper, 21: Connector-side terminal conductor, 21A: Elastic part, 23A: Relay coupling, 24: Lead terminal conductor

## Claims

1. A circuit module having a connector (20B), comprising:
a module casing (20) constituted by a resin molded member with which the connector (208) is integrally formed and in which a connector-side terminal conductor (21) is provided by insert molding;
a circuit board (18) placed on an inner surface of the module casing;
wherein the module casing (20) is provided with a stopper (20D) for retaining an one-side edge of the circuit board (18);
wherein an one end side part of the connector-side terminal conductor (21) is exposed on the inner surface of the module casing (20), **characterized in that** the exposed part has a curved portion so as to be an elastic part (21A), and the elastic part (21A) is configured to be located opposite to the stopper (20) across an installation space of the circuit board (18) from the stopper (20D); and
wherein the circuit board (18) is provided with a circuit-side terminal conductor (18D) thereon, the circuit-side terminal conductor (18D) is configured to extend up to an other-side edge of the circuit board (18) on the elastic part side such that a curved surface of the elastic part (21A) is pressed against the circuit side terminal conductor (18D) at the other-side edge to retain the circuit board (18), and thereby the circuit board (18) is caught with the elastic part (21A) and the stopper (20D).

2. The circuit module according to Claim 1, **characterized in that** the module casing also serves as a gear cover or a cover for a rotation angle sensor.

3. The circuit module according to Claim 1, **characterized in that** the connector-side terminal conductor comprises a conductor used for a sensor and a conductor used for a motor.

4. The circuit module according to Claim 1, **characterized in that** the stopper is an elastic projection or a wall part which is formed integrally with a cover member.

## Patentansprüche

1. Schaltungsmodul mit einem Verbinder (20B), das Folgendes enthält:
ein Modulgehäuse (20), das durch ein aus Harz geformtes Element gebildet ist, mit dem der Verbinder (20B) einteilig ausgebildet ist und in dem ein verbinderseitiger Anschlussleiter (21) durch Umspritzen vorgesehen ist;
eine Leiterplatte (18), die auf einer inneren Oberfläche des Modulgehäuses platziert ist;
wobei das Modulgehäuse (20) mit einem Stopper (20D) zum Zurückhalten einer Kante auf einer Seite der Leiterplatte (18) versehen ist;
wobei ein Teil auf Seiten eines Endes des verbinderseitigen Anschlussleiters (21) auf der inneren Oberfläche des Modulgehäuses (20) freiliegt, **dadurch gekennzeichnet, dass** der freiliegende Teil einen gekrümmten Abschnitt hat, um ein elastischer Teil (21A) zu sein, und der elastische Teil (21A) so konfiguriert ist, dass er sich in Bezug auf einen von dem Stopper (20D) ausgehenden Installationsraum der Leiterplatte (18) gegenüber dem Stopper (20D) befindet; und
wobei die Leiterplatte (18) mit einem auf ihr befindlichen schaltungsseitigen Anschlussleiter (18D) versehen ist, wobei der schaltungsseitige Anschlussleiter (18D) so konfiguriert ist, dass er sich bis zu einer Kante auf der anderen Seite der Leiterplatte (18) auf Seiten des elastischen Teils erstreckt, so dass eine gekrümmte Oberfläche des elastischen Teils (21A) gegen den schaltungsseitigen Anschlussleiter (18D) an der Kante auf der anderen Seite gepresst wird, um die Leiterplatte (18) zurückzuhalten, wodurch die Leiterplatte (18) mit dem elastischen Teil (21A) und dem Stopper (20D) eingeklemmt ist.

2. Schaltungsmodul nach Anspruch 1, **dadurch gekennzeichnet, dass** das Modulgehäuse auch als Zahnradabdeckung oder als Abdeckung für ein Drehwinkelsensor dient.

3. Schaltungsmodul nach Anspruch 1, **dadurch gekennzeichnet, dass** der verbinderseitige Anschlussleiter einen Leiter, der für einen Sensor verwendet wird, und einen Leiter, der- für einen Motor verwendet wird, umfasst.

4. Schaltungsmodul nach Anspruch 1, **dadurch gekennzeichnet, dass** der Stopper ein elastischer Vorsprung oder ein mit dem Abdeckungselement einteilig ausgebildeter Wandteil ist.

## Revendications

1. Module de circuit ayant un connecteur (20B), comprenant :
un boîtier de module (20) constitué par un élément moulé en résine avec lequel le connecteur (20B) est intégralement formé et dans lequel un conducteur terminal (21) du côté connecteur est réalisé par moulage sur insert ;
une carte à circuits (18) placée sur une surface intérieure du boîtier de module ;
dans lequel le boîtier de module (20) est doté d'un arrêt (20D) pour retenir une bordure sur un côté de la carte à circuits (18) ;
dans lequel une partie latérale d'extrémité du conducteur terminal côté connecteur (21) est exposée sur la surface intérieure du boîtier de module (20),
**caractérisé en ce que**
la partie exposée a une portion incurvée de manière à être une partie élastique (21A), et la partie élastique (21A) est configurée pour être située à l'opposé de l'arrêt (20D) à travers un espace d'installation de la carte à circuits (18) depuis l'arrêt (20D) ; et
dans lequel la carte à circuits (18) est dotée d'un conducteur terminal côté circuit (18D) sur elle-même, le conducteur terminal côté circuit (18D) est configuré pour s'étendre jusqu'à une bordure sur un autre côté de la carte à circuits (18) sur le côté de la partie élastique de telle façon qu'une surface incurvée de la partie élastique (21A) soit pressée contre le conducteur terminal du côté circuit (18D) à la bordure sur l'autre côté afin de retenir la carte à circuits (18), et grâce à cela la carte à circuits (18) est emprisonnée avec la partie élastique (21A) et avec l'arrêt (20D).

2. Module de circuit selon la revendication 1, **caractérisé en ce que** le boîtier de module sert également de couvercle de mécanisme ou de couvercle pour un capteur d'angle de rotation.

3. Module de circuit selon la revendication 1, **caractérisé en ce que** le conducteur terminal du côté connecteur comprend un conducteur utilisé pour un capteur et un conducteur utilisé pour un moteur.

4. Module de circuit selon la revendication 1, **caractérisé en ce que** l'arrêt est une projection élastique ou une partie de paroi qui est formée intégralement avec un élément de couverture.
